# EUROPEAN PATENT APPLICATION

(11) **EP 1 408 480 A1**
(43) Date of publication of application: **14.04.2004**
(21) Application number: 02741411.9
(22) Date of filing: 03.07.2002
(51) Int. Cl.: G09G 3/30, G09G 3/36, G02F 1/133, H03M 1/76

(54) **DA CONVERTING CIRCUIT, DISPLAY USING THE SAME, AND MOBILE TERMINAL HAVING THE DISPLAY**

(30) Priority: 16.07.2001 JP 2001214905
(71) Applicant: Sony Corporation, Tokyo 141-0001 (JP)
(72) Inventor: KIDA, Yoshitoshi Sony Corporation, Tokyo 141-0001 (JP); NAKAJIMA, Yoshiharu Sony Corporation, Tokyo 141-0001 (JP); MAEKAWA, Toshikazu Sony Corporation, Tokyo 141-0001 (JP)
(74) Representative: Müller - Hoffmann & Partner
(86) International application number: PCT/JP2002/006757
(87) International publication number: WO 2003/009271

(57) **Abstract**

A D/A converter circuit according to the present invention allows adaptation to multi-gradation by reducing the circuit size. A reference-voltage-selection-type D/A converter circuit that converts 4-bit digital data into an analog signal having 16 voltage values V1 to V16 generates in a reference voltage generating circuit (11) four reference voltages Vref1 to Vref4 having four voltage values in time series and generates a selection signal in a selection signal generating circuit (12) based on low-order two bits of the digital data. A selection circuit (13) selects by time-sharing one of the four voltage values of each of the reference voltages Vref1 to Vref4 based on this selection signal and outputs the analog signal of the selected voltage value to an output line (15).

## Description

### Technical Field

The present invention relates to digital-to-analog converter (hereinafter referred to as D/A converter) circuits, display units with such D/A converter circuits, and mobile terminals having such display units. More particularly, it relates to a reference-voltage-selection-type D/A converter circuit, a display unit with a drive circuit that includes such a D/A converter circuit, and a mobile terminal having such a display unit as an output display.

### Background Art

In recent years, mobile terminals such as mobile telephones or personal digital assistants (PDAs) have been becoming increasingly common. One of the factors for rapid popularization of these mobile terminals is a display unit included therein as an output display. Such display units includes a liquid crystal display unit, serving as the output display, which uses liquid crystal cells as electro-optical devices of pixels. The liquid crystal display unit requires, in principle, no driving electric power and is a low power consumption display device. The same applies to an electroluminescence (EL) display unit using EL devices as the electro-optical devices of the pixels.

In the liquid crystal display unit or the like, a digital interface drive circuit is likely to be integrally formed with a pixel area (display area) on the same substrate. Such a drive-circuit-integrated liquid crystal display unit has the following structure: a horizontal drive system and a vertical drive system are disposed around a pixel area, in which many pixels using polysilicon thin film transistors (TFTs) as switching devices are arranged in a matrix, and these drive systems are integrally formed with the display area on the same substrate (hereinafter referred to as an LCD panel), with the polysilicon TFTs.

The digital interface drive circuit uses a D/A converter circuit for converting inputted digital data into an analog signal. Such D/A converter circuits include a reference-voltage-selection-type D/A converter circuit that selects a reference voltage corresponding to digital image data from among a plurality of reference voltages and outputs the selected reference voltage as an analog image signal.

There is a big problem when fabricating the drive-circuit-integrated liquid crystal display unit having the structure described above, in that the digital interface drive circuit that is integrally formed on the LCD panel occupies a large area, that is, an area around the pixel area (this area is hereinafter referred to as a frame) is large. Particularly, in the drive-circuit-integrated liquid crystal display unit having the reference-voltage-selection-type D/A converter circuit, the D/A converter circuit occupies a large area, thereby causing a major problem when attempting to reduce the frame size in the LCD panel.

In other words, the reference-voltage-selection-type D/A converter circuit is structured so as to have a plurality of reference voltage lines for transmitting as many reference voltages as the number of display gradations and a gradation selection circuit that includes a set of individual transistor switches connected between each of these reference voltage lines and each data line of the pixel area. This gradation selection circuit occupies a large area within the D/A converter circuit. Since the number of required reference voltage lines is as many as the number of the display gradations, the area occupied by these reference voltage lines, that is, the area occupied by wiring when routing the reference voltage lines to the D/A converter circuit within the LCD panel becomes large.

Thus, multi-gradation causes the digital interface drive circuit to increase in size. The increase of the area of the drive circuit leads to an increase in size of the frame in the LCD panel. In existing process technologies, the increment of the number of bits representing the gradations by one bit, for example, from two bits to three bits or from three bits to four bits, causes the frame to be doubled in size or more.

In addition, since the number of the transistors included in the gradation selection circuit significantly increases by the multi-gradation, the size of the transistors must be small in order to arrange them within a limited area of the frame. When the size of the transistors is small, a large amount of current cannot be passed through. Therefore, the multi-gradation lowers the writing property onto the data lines in the D/A converter circuit. For these reasons, adaptation to the multi-gradation is difficult to realize in fact in the known art.

An object of the present invention is to provide a D/A converter circuit of a reference voltage selection type, which makes it possible to adapt to the multi-gradation by the reduction in circuit size, a display unit with such a D/A converter circuit, and a mobile terminal having such a display unit, thereby overcoming the above-described drawbacks.

### Disclosure of Invention

A D/A converter circuit according to the present invention is configured so as to include reference voltage generating means for generating a reference voltage having voltage values corresponding to a plurality of signal levels in time series; selection signal generating means for generating a selection signal for selecting one of the voltage values corresponding to the plurality of signal levels in the reference voltages based on bit information concerning digital data; and selecting means for selecting by time-sharing one of the voltage values corresponding to the plurality of signal levels in the reference voltage based on the selection signal outputted from the selection signal generating means and for outputting an analog signal of the selected voltage value. This D/A converter circuit serves as a reference-voltage-selection-type D/A converter circuit included in a drive circuit of a display unit. The display unit with the drive circuit having the reference-voltage-selection-type D/A converter circuit is included in a mobile terminal as an output display.

In the D/A converter circuit that has the structure described above, the display unit with such a D/A converter circuit, and the mobile terminal having such a display unit, the number of reference voltage lines for transmitting the reference voltage is decreased by outputting from the reference voltage generating means the reference voltage, which has as voltage values corresponding to the plurality of signal levels (a plurality of gradation levels for the display unit) in time series. A selection circuit selects by time-sharing one of the voltage values corresponding to the plurality of signal levels in the reference voltage outputted from reference voltage generating means, based on the selection signal outputted from the selection signal generating means, and outputs the analog signal of the selected voltage value.

### Brief Description of the Drawings

Fig. 1 is a circuit diagram showing an exemplary D/A converter circuit according to a first embodiment of the present invention.
Fig. 2 is a timing chart illustrating the circuit operation of the D/A converter circuit according to the first embodiment.
Fig. 3 is circuit diagram showing an exemplary D/A converter circuit according to a second embodiment of the present invention.
Fig. 4 is a timing chart illustrating the circuit operation of the D/A converter circuit according to the second embodiment.
Fig. 5 is circuit diagram showing an exemplary D/A converter circuit according to a third embodiment of the present invention.
Fig. 6 is a timing chart illustrating the circuit operation of the D/A converter circuit according to the third embodiment.
Fig. 7 is a block diagram showing a structure example of a drive-circuit-integrated liquid crystal display unit according to the present invention.
Fig. 8 is a circuit diagram showing an example of the structure of a pixel area.
Fig. 9 is an external view schematically showing the structure of a mobile telephone according to the present invention.

### Best Mode for Carrying Out the Invention

Embodiments of the present invention will now be described in detail with reference to the accompanying drawings.

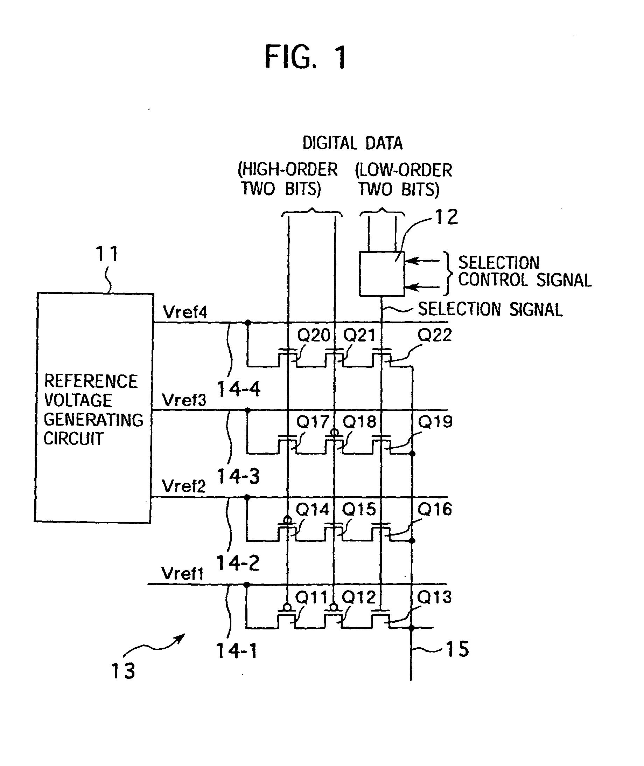

Fig. 1 is a circuit diagram showing an exemplary D/A converter circuit according to a first embodiment of the present invention. A reference-voltage-selection-type D/A converter circuit that converts 4-bit digital data into analog signals having 16 voltage values is used in this embodiment.. The reference-voltage-selection-type D/A converter circuit according to this embodiment includes a reference voltage generating circuit 11, a selection signal generating circuit 12, and a selection circuit (decoder) 13.

The reference voltage generating circuit 11 generates four reference voltages Vref1 to Vref4 for 16 voltage values V1 to V16. Specifically, it generates a reference voltage Vref1 having voltage values V1 to V4, a reference voltage Vref2 having voltage values V5 to V8, a reference voltage Vref3 having voltage values V9 to V12, and a reference voltage Vref4 having voltage values V13 to V16. In other words, each of the reference voltages Vref1 to Vref4 has four voltage values in time series.

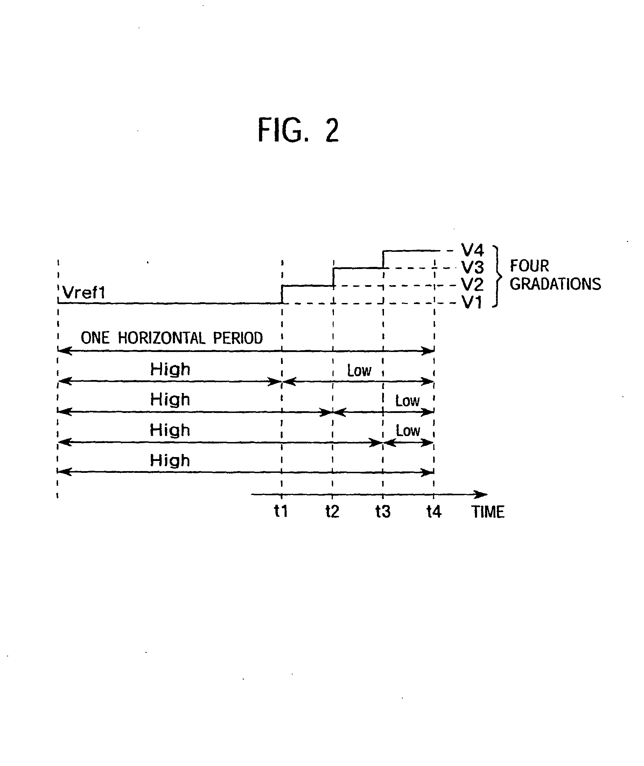

For example, the reference voltage Vref1 has four voltage values V1 to V4 in time series, as shown in Fig. 2. The reference voltage Vref1 is repeated at regular periods, for example, it is repeated every horizontal period (1H) when used in a display unit as described below, to be outputted from the reference voltage generating circuit 11. The voltage value V1 can be selected when the reference voltage Vref1 is selected at time t1; the voltage value V2 can be selected when it is selected at time t2; the voltage value V3 can be selected when it is selected at time t3; and the voltage value V4 can be selected when it is selected at time t4.

Although each of the other reference voltages Vref2 to Vref4 has four voltage values different from those of the reference voltage Vref1, they have the same timing relationship as the reference voltage Vref1. Therefore, 16 voltage values V1 to V16 can be set with the four reference voltages Vref1 to Vref4. These four reference voltages Vref1 to Vref4 are transmitted from the reference voltage generating circuit 11 to the selection circuit 13 through reference voltage lines 14-1 to 14-4.

The 4-bit digital data is divided into, for example, high-order 2-bit data and low-order 2-bit data. The high-order 2-bit data is supplied to the selection circuit 13 and is used for determining which reference voltage should be selected from among the four reference voltages Vref1 to Vref4, as described below. The low-order 2-bit data is supplied to the selection signal generating circuit 12, to which a 2-bit selection control signal is also inputted.

The selection signal generating circuit 12 consists of simple logic circuits. It generates, based on the low-order 2-bit data and the 2-bit selection control signal, selection signals for determining which voltage value should be selected from among the four voltage values with respect to each of the reference voltages Vref1 to Vref4. The low-order 2-bit data has information corresponding to the four voltage values, whereas the 2-bit selection control signal has information corresponding to times t1 to t4 in the timing chart in Fig. 2.

Specifically, the selection signal generating circuit 12 generates the four selection signals during one horizontal period based on the low-order 2-bit data and the 2-bit selection control signal. That is, it generates a selection signal being at an "H" level until time t1, a selection signal being at an "H" level until time t2, a selection signal being at an "H" level until time t3, and a selection signal being at an "H" level until time t4. These selection signals are supplied to the selection circuit 13 together with the high-order 2-bit data.

The selection circuit 13 includes P-channel MOS (hereinafter referred to as PMOS) transistors Q11 and Q12 and an N-channel MOS (hereinafter referred to as NMOS) transistor Q13, which are connected in series between the reference voltage line 14-1 and an output line 15; a PMOS transistor Q14 and NMOS transistors Q15 and Q16, which are connected in series between the reference voltage line 14-2 and the output line 15; an NMOS transistor Q17, a PMOS transistor Q18, and an NMOS transistor Q19, which are connected in series between the reference voltage line 14-3 and the output line 15; and NMOS transistors Q20, Q21, and Q22, which are connected in series between the reference voltage line 14-4 and the output line 15.

When the logic states of the high-order two bits of the digital data are (00), both the PMOS transistors Q11 and Q12 switch ON and the reference voltage Vref1 is selected. When the logic states of the high-order two bits of the digital data are (01), both the PMOS transistor Q14 and the NMOS transistor Q12 switch ON and the reference voltage Vref2 is selected. When the logic states of the high-order two bits of the digital data are (10), both the NMOS transistor Q17 and the PMOS transistor Q12 switch ON and the reference voltage Vref3 is selected. When the logic states of the high-order two bits of the digital data are (11), both the NMOS transistors Q20 and Q21 switch ON and the reference voltage Vref4 is selected.

Referring to the timing chart in Fig. 2, each of the four voltage values V1 to V4 is selected by time-sharing when the NMOS transistor Q13 corresponding to the reference voltage Vref1 switches ON. That is, the smallest voltage value V1 is selected when the selection signal outputted from the selection signal generating circuit 12 stays at an "H" level until time t1; the second smallest voltage value V2 is selected when it stays at an "H" level until time t2; the second largest voltage value V3 is selected when it stays at an "H" level until time t3; and the largest voltage value V4 is selected when it stays at an "H" level until time t4.

Referring to the timing chart in Fig. 2, the voltage values V1, V2, V3, and V4 are determined by timing (times t1, t2, t3, and t4) when the selection signals are in transition from an "H" level to an "L" level. With respect to the reference voltages Vref2 to Vref4, as in the reference voltage Vref1, the selection signals are outputted from the selection signal generating circuit 12. One of the four voltage values is selected by time-sharing when the NMOS transistor Q16, Q19, or Q22 corresponding to each of the reference voltages switches ON.

As described above, the reference-voltage-selection-type D/A converter circuit, which converts the 4-bit digital data into the analog signals having the 16 voltage values V1 to V16, generates the four reference voltages Vref1 to Vref4, each having the four voltage values in time series, and also generates the selection signals based on bit information concerning the digital data. The D/A converter circuit selects one of the four voltage values of each of the reference voltages Vref1 to Vref4 by time-sharing based on these selection signals. The analog signal of the selected voltage value is outputted to the output line 15. Such a structure provides the following operative effects.

When the 4-bit digital data is converted into the analog signals having the 16 voltage values V1 to V16, a structure that generates 16 reference voltages is employed in the known art. In this structure, 16 reference voltage lines are required. Since it is necessary to select one of the 16 reference voltages based on the 4-bit digital data, the selection circuit must include 64 (= 16 × 4) transistors.

In contrast, it is enough for the reference-voltage-selection-type D/A converter circuit according to the embodiment of the present invention to generate four reference voltages Vref1 to Vref4. Thus, only four reference voltage lines are required. Furthermore, since it is enough for this circuit to select one of the 16 voltage values V1 to V16 by time-sharing based on the high-order 2-bit data and the 1-bit selection signal, the selection circuit 13 must include only 12 (= 4 × 3) transistors, as shown in Fig. 1. Accordingly, significant reduction in circuit size, including wiring space for the reference voltage lines 14-1 to 14-4, can be achieved.

In addition, since the number of the transistors included in the selection circuit 13 can be significantly decreased, individual transistor size can be increased in accordance with extra arrangement space caused by this decrease and large current flows through the transistors. Therefore, the writing property of the analog signals onto the output line 15 can be improved. Furthermore, the decrease in the number of the reference voltage lines makes it possible to reduce power consumption by the amount for driving the capacity of the reduced reference voltage lines.

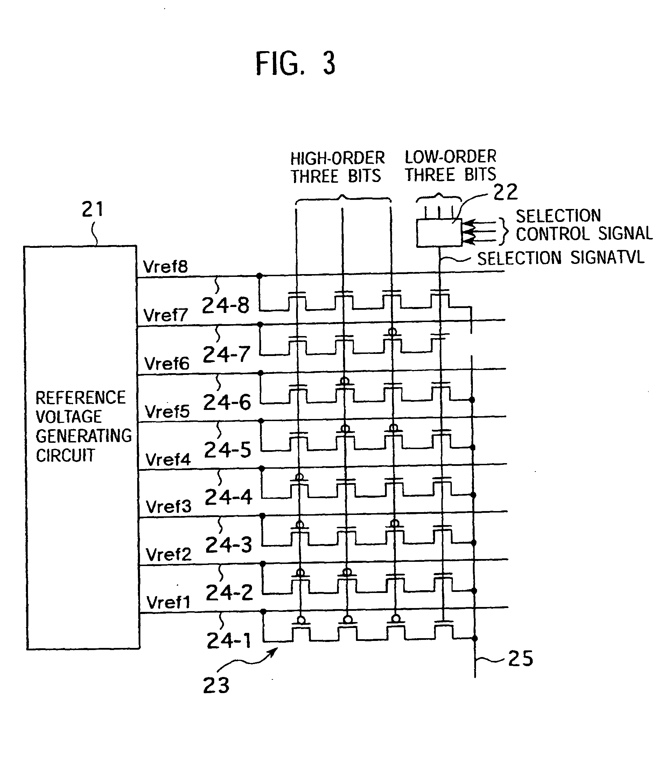

Fig. 3 is a circuit diagram showing an exemplary D/A converter circuit according to a second embodiment of the present invention. A reference-voltage-selection-type D/A converter circuit that converts 6-bit digital data into analog signals having 64 voltage values V1 to V64 is used in this embodiment. In this circuit, the 6-bit digital data is divided into high-order three bits and low-order three bits.

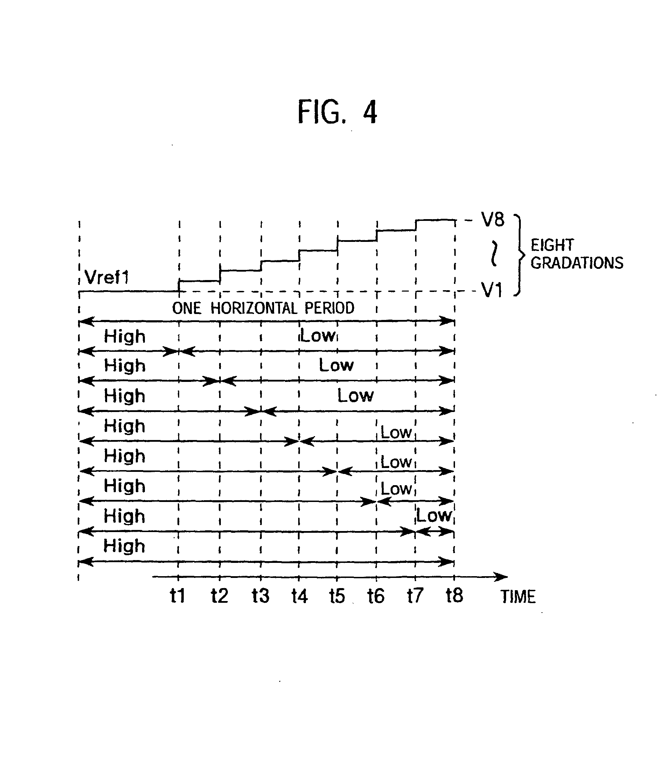

A reference voltage generating circuit 21 generates eight reference voltages Vref1 to Vref8 corresponding to the high-order three bits for 64 voltage values V1 to V64. Each of the eight reference voltages Vref1 to Vref8 has eight voltage values in time series corresponding to the lower three bits. For example, the reference voltage Vref1, which is the smallest voltage, has eight voltage values V1 to V8 in time series, as shown in Fig. 4. The reference voltage Vref1 is repeated at regular periods, for example, it is repeated every horizontal period (1H) when used in a display unit as described below, to be outputted from the reference voltage generating circuit 21.

The voltage value V1 can be selected when the reference voltage Vref1 is selected at time t1; the voltage value V2 can be selected when it is selected at time t2; the voltage value V3 can be selected when it is selected at time t3; the voltage value V4 can be selected when it is selected at time t4; the voltage value V5 can be selected when it is selected at time t5; the voltage value V6 can be selected when it is selected at time t6; the voltage value V7 can be selected when it is selected at time t7; and the voltage value V8 can be selected when it is selected at time t8.

Although each of the other reference voltages Vref2 to Vref8 has eight voltage values different from those of the. reference voltage Vref1, they have the same timing relationship as the reference voltage Vref1. Therefore, 64 voltage values V1 to V64 can be set with eight reference voltages Vref1 to Vref8. These eight reference voltages Vref1 to Vref8 are transmitted from the reference voltage generating circuit 21 to a selection circuit 23 through reference voltage lines 24-1 to 24-8.

Among the 6-bit digital data, the high-order 3-bit data is supplied to the selection circuit 23 and is used for determining which reference voltage should be selected from among the eight reference voltages Vref1 to Vref8, as described below. The low-order 3-bit data is supplied to a selection signal generating circuit 22, together with a 3-bit selection control signal. The low-order 3-bit data has information corresponding to the eight voltage values, whereas the 3-bit selection control signal has information corresponding to times t1 to t8 in the timing chart in Fig. 4.

The selection signal generating circuit 22 consists of simple logic circuits. It generates, based on the low-order 3-bit data and the 3-bit selection control signal, selection signals for determining which voltage value should be selected from among the eight voltage values with respect to each of the reference voltages Vref1 to Vref8.

Specifically, the selection signal generating circuit 22 generates the eight selection signals during one horizontal period. That is, it generates a selection signal being at an "H" level until time t1, a selection signal being at an "H" level until time t2, a selection signal being at an "H" level until time t3, a selection signal being at an "H" level until time t4, a selection signal being at an "H" level until time t5, a selection signal being at an "H" level until time t6, a selection signal being at an "H" level until time t7, and a selection signal being at an "H" level until time t8. These selection signals are supplied to the selection circuit 23 together with the high-order 3-bit data.

The selection circuit 23 has four MOS transistors connected in series between each of the reference voltage lines 24-1 to 24-8 and an output line 25. That is, the four MOS transistors are provided for each of the reference voltage lines 24-1 to 24-8. Among these MOS transistors, conductivity types (P-channel or N-channel) of the three MOS transistors corresponding to the high-order 3-bit data are determined based on the logic states of the high-order three bits, as in the first embodiment. Based on the logic states of the high-order three bits, one of the reference voltage lines 24-1 to 24-8, that is, one of the eight reference voltages Vref1 to Vref8, is selected.

Referring to the timing chart in Fig. 4, each of the eight voltage values V1 to V8 is selected by time-sharing when the NMOS transistor corresponding to the reference voltage Vref1 switches ON. That is, the voltage value V1 is selected when the selection signal outputted from the selection signal generating circuit 22 stays at an "H" level until time t1; the voltage value V2 is selected when it stays at an "H" level until time t2; the voltage value V3 is selected when it stays at an "H" level until time t3; the voltage value V4 is selected when it stays at an "H" level until time t4; the voltage value V5 is selected when it stays at an "H" level until time t5; the voltage value V6 is selected when it stays at an "H" level until time t6; the voltage value V7 is selected when it stays at an "H" level until time t7; and the voltage value V8 is selected when it stays at an "H" level until time t8.

Referring to the timing chart in Fig. 4, the voltage values V1 to V8 are determined by timing (times t1 to t8) when the selection signals are in transition from an "H" level to an "L" level. With respect to the reference voltages Vref2 to Vref8, as in the reference voltage Vref1, the selection signals are outputted from the selection signal generating circuit 22. One of the eight voltage values is selected by time-sharing when the NMOS transistor corresponding to each of the reference voltages switches ON.

As described above, the reference-voltage-selection-type D/A converter circuit, which converts the 6-bit digital data into the analog signals having the 64 voltage values V1 to V64, divides the 6-bit digital data into the high-order three bits and the low-order three bits, and generates the eight reference voltages Vref1 to Vref8, each having the eight voltage values in time series. The D/A converter circuit selects one of the eight voltage values of each of these reference voltages Vref1 to Vref8 by time-sharing. Such a structure provides the following operative effects.

When the 6-bit digital data is converted into the analog signals having the 64 voltage values V1 to V64, a structure that generates 64 reference voltages is employed in the known art. In this structure, 64 reference voltage lines are required. Since it is necessary to select one of the 64 reference voltages based on the 6-bit digital data, the selection circuit must include 384 (= 64 × 6) transistors.

In contrast, it is enough for the reference-voltage-selection-type D/A converter circuit according to the embodiment of the present invention to generate eight reference voltages Vref1 to Vref8. Thus, only eight reference voltage lines are required. Furthermore, since it is enough for this circuit to select one of the 64 voltage values V1 to V64 by time-sharing based on the high-order 3-bit data and the 1-bit selection signal, the selection circuit 23 must include only 32 (= 8 × 4) transistors, as shown in Fig. 3. Accordingly, significant reduction in circuit size, including wiring space for the reference voltage lines 24-1 to 24-8, can be achieved.

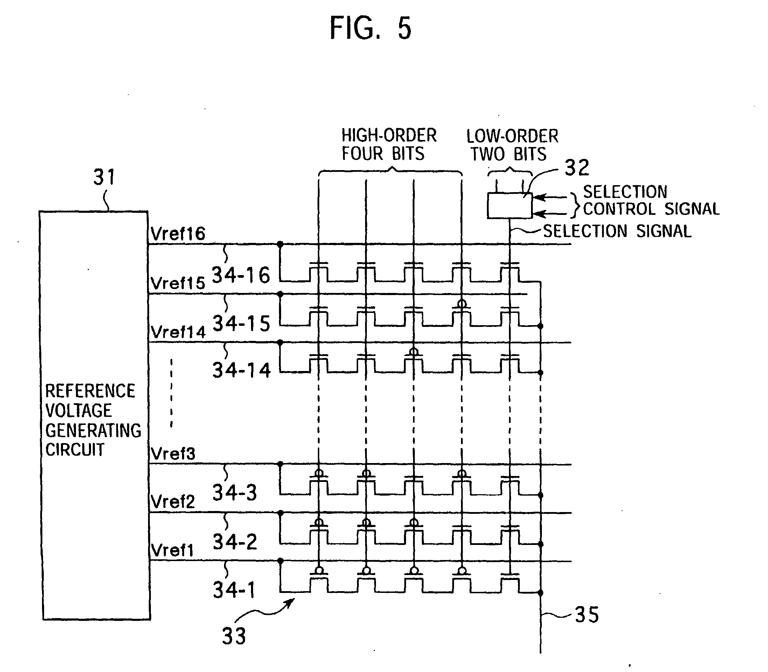

Fig. 5 is a circuit diagram showing an exemplary D/A converter circuit according to a third embodiment of the present invention. A reference-voltage-selection-type D/A converter circuit that converts 6-bit digital data into analog signals having 64 voltage values is used in this embodiment. In this circuit, the 6-bit digital data is divided into high-order four bits and low-order two bits.

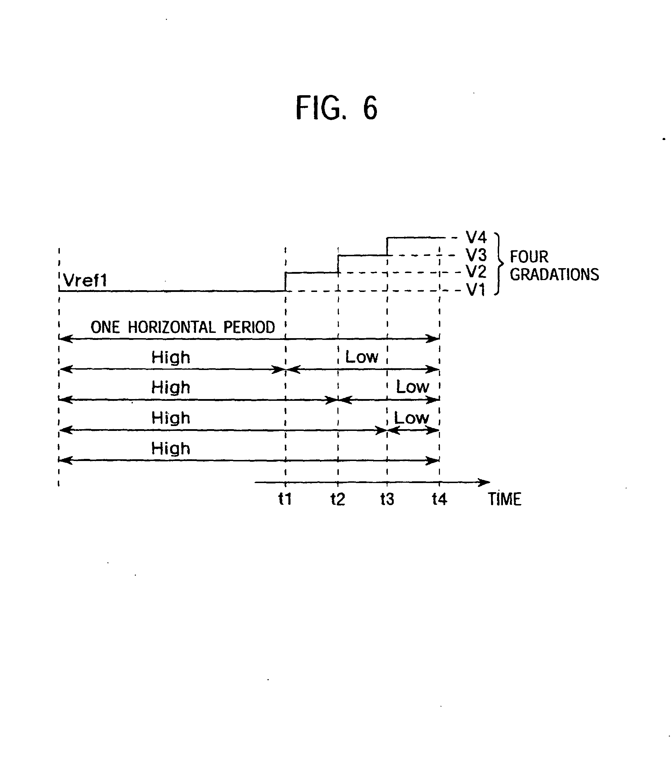

A reference voltage generating circuit 31 generates 16 reference voltages Vref1 to Vref16 corresponding to the high-order four bits for 64 voltage values V1 to V64. Each of the 16 reference voltages Vref1 to Vref16 has four voltage values in time series corresponding to the lower two bits. For example, the reference voltage Vref1, which is the smallest voltage, has four voltage values V1 to V4 in time series, as shown in Fig. 6. The reference voltage Vref1 is repeated at regular periods, for example, it is repeated every horizontal period (1H) when used in a display unit as described below, to be outputted from the reference voltage generating circuit 31.

The voltage value V1 can be selected when the reference voltage Vref1 is selected at time t1; the voltage value V2 can be selected when it is selected at time t2; the voltage value V3 can be selected when it is selected at time t3; and the voltage value V4 can be selected when it is selected at time t4. Although each of the other reference voltages Vref2 to Vref16 has four voltage values different from those of the reference voltage Vref1, they have the same timing relationship as the reference voltage Vref1. Therefore, 64 voltage values V1 to V64 can be set with 16 reference voltages Vref1 to Vref16. These 16 reference voltages Vref1 to Vref16 are transmitted from the reference voltage generating circuit 31 to a selection circuit 33 through reference voltage lines 34-1 to 34-16.

Among the 6-bit digital data, the high-order 4-bit data is supplied to the selection circuit 33 and is used for determining which reference voltage should be selected from among the 16 reference voltages Vref1 to Vref16, as described below. The low-order 2-bit data is supplied to a selection signal generating circuit 32, together with a 2-bit selection control signal. The low-order 2-bit data has information corresponding to the four voltage values, whereas the 2-bit selection control signal has information corresponding to times t1 to t4 in the timing chart in Fig. 6.

The selection signal generating circuit 32 consists of simple logic circuits. It generates, based on the low-order 2-bit data and the 2-bit selection control signal, selection signals for determining which voltage value should be selected from among the four voltage values with respect to each of the reference voltages Vref1 to Vref16. Specifically, the selection signal generating circuit 32 generates the four selection signals during one horizontal period. That is, it generates a selection signal being at an "H" level until time t1, a selection signal being at an "H" level until time t2, a selection signal being at an "H" level until time t3, and a selection signal being at an "H" level until time t4. These selection signals are supplied to the selection circuit 33 together with the high-order 4-bit data.

The selection circuit 33 has five MOS transistors connected in series between each of the reference voltage lines 34-1 to 34-16 and an output line 35. That is, the five MOS transistors are provided for each of the reference voltage lines 34-1 to 34-16. Among these MOS transistors, conductivity types of the four MOS transistors corresponding to the high-order 4-bit data are determined based on the logic states of the high-order four bits. Based on the logic states of the high-order four bits, one of the reference voltage lines 34-1 to 34-16, that is, one of 16 reference voltages Vref1 to Vref16, is selected.

Referring to the timing chart in Fig. 6, each of the four voltage values V1 to V4 is selected by time-sharing when the NMOS transistor corresponding to the reference voltage Vref1 switches ON. That is, the voltage value V1 is selected when the selection signal outputted from the selection signal generating circuit 32 stays at an "H" level until time t1; the voltage value V2 is selected when it stays at an "H" level until time t2; the voltage value V3 is selected when it stays at an "H" level until time t3; and the voltage value V4 is selected when it stays at an "H" level until time t4.

Referring to the timing chart in Fig. 6, the voltage values V1 to V4 are determined by timing (times t1 to t4) when the selection signals in transition from an "H" level to an "L" level. With respect to the reference voltages Vref2 to Vref16, as in the reference voltage Vref1, the selection signals are outputted from the selection signal generating circuit 32. One of the four voltage values is selected by time-sharing when the NMOS transistor corresponding to each of the reference voltages switches ON.

As described above, the reference-voltage-selection-type D/A converter circuit, which converts the 6-bit digital data into the analog signals having the 64 voltage values V1 to V64, divides the 6-bit digital data into the high-order four bits and the low-order two bits, and generates the 16 reference voltages Vref1 to Vref16, each having the four voltage values in time series. The D/A converter circuit selects one of the four voltage values of each of these reference voltages Vref1 to Vref16 by time-sharing. Such a structure provides the following operative effects.

In other words, only 16 reference voltage lines are required. Furthermore, since it is enough for this circuit to select one of the 64 voltage values V1 to V64 by time-sharing based on the high-order 4-bit data and the 1-bit selection signal, the selection circuit 33 must include only 80 (= 16 × 5) transistors. Accordingly, the number of the reference voltage lines and that of the MOS transistors are significantly reduced, compared with the known art in which 64 reference voltage lines and 384 transistors, included in the selection circuit, are required. Thus, significant reduction in circuit size, including wiring space for the reference voltage lines, can be achieved.

In the above embodiments of the present invention, the reference-voltage-selection-type D/A converter circuit, in which the 4-bit digital data is converted into the analog signals having the 16 voltage values V1 to V16, and the reference-voltage-selection-type D/A converter circuit, in which the 6-bit digital data is converted into the analog signals having the 64 voltage values V1 to V64, are described by way of example. However, the number of bits of the digital data is not limited to those numbers. The number of high-order bits and that of low-order bits can be arbitrarily set.

The reference-voltage-selection-type D/A converter circuit according to each of the above three embodiments can be used as, for example, a reference-voltage-selection-type D/A converter circuit included in a drive circuit for a drive-circuit-integrated display unit.

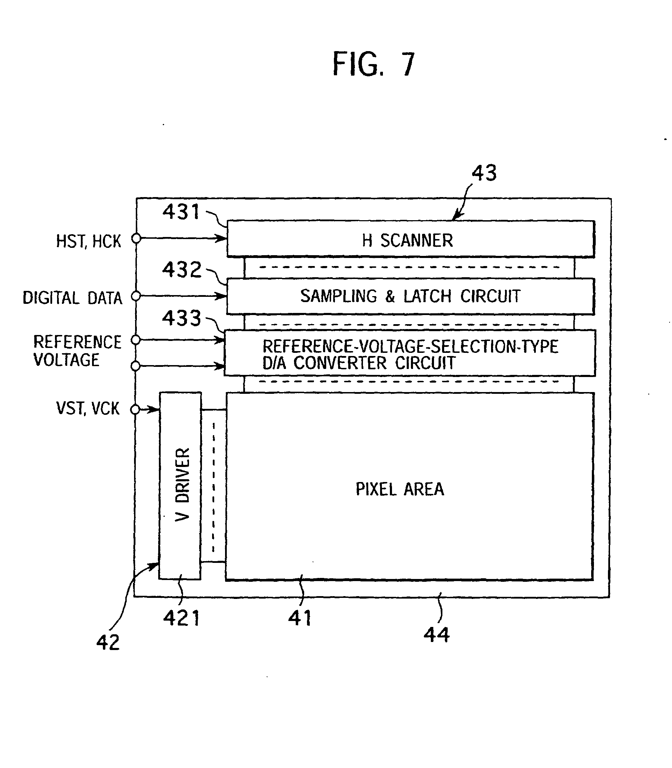

Fig. 7 is a block diagram showing a structure example of a drive-circuit-integrated liquid crystal display unit. Referring to Fig. 7, a vertical (V) drive system 42 is disposed, for example, on the left of a pixel area 41 in which many pixels are arranged in a matrix, and a horizontal (H) drive system 43 is disposed, for example, on the upper side of the pixel area 41. These drive systems 42 and 43 are integrally formed with the pixel area 41 on the same transparent insulating substrate (for example, a glass substrate), with, for example, a polysilicon TFT. This first transparent insulating substrate faces a second transparent insulating substrate with a predetermined gap and a liquid crystal layer is held therebetween. The first and second substrates and the liquid crystal layer constitute an LCD panel 44.

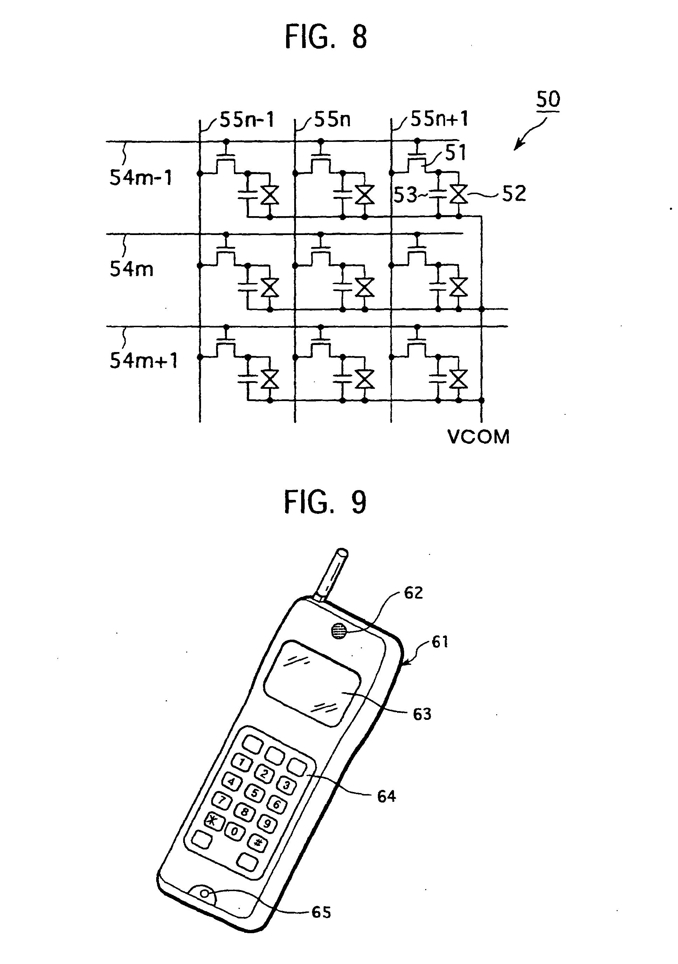

Fig. 8 shows an example structure of the pixel area 41. Referring to Fig. 8, each pixel 50 arranged in a matrix includes a TFT 51 serving as a pixel transistor; a liquid crystal cell 52, its pixel electrode being connected to the drain electrode of the TFT 51; and an auxiliary capacitor, one electrode of which being connected to the drain electrode of the TFT 51. Gate electrodes of TFTs 51 are connected to gate lines ..., 54m-1, 54m, 54m+1, ... and source electrodes of the TFTs 51 are connected to data lines (signal lines) ..., 55n-1, 55n, 55+1, .... A common voltage VCOM is applied to a counter electrode of the liquid crystal cell 52 and to the other electrode of the auxiliary capacitor 53.

A 1H-inversion drive method, in which the polarities of signals applied to each pixel 50 are inverted every horizontal period, is generally employed for driving this pixel area 41. Combining a common inversion drive method with this 1H inversion drive method reduces the voltage in the horizontal drive system 43. In the common inversion drive method, the common voltage VCOM commonly applied to the counter electrode of the liquid crystal cell 52 in each pixel 50 is inverted every horizontal period.

The vertical drive system 42 includes a vertical (V) driver 421, which consists of, for example, a shift register. The vertical drive system 42 performs a vertical scan for selecting each pixel in the pixel area 41 line by line by shifting in synchronization with a vertical clock pulse VCK in response to a vertical start pulse VST. The horizontal drive system 43 includes, for example, a horizontal (H) scanner 431, a sampling and latch circuit 432, and a D/A converter circuit 433. The H scanner 431 consists of, for example, a shift register, and it successively outputs sampling pulses in synchronization with a horizontal clock pulse HCK in response to a horizontal start pulse HST.

The sampling and latch circuit 432 sequentially samples digital data in synchronization with the sampling pulses successively outputted from the H scanner 431 and latches the sampled data. The D/A converter circuit 433 converts the digital data, which is sampled and latched in the sampling and latch circuit 432, into analog signals every data line ..., 55n-1, 55n, 55n+1, ... of the pixel area 41 and writes them onto these data lines.

The reference-voltage-conversion-type D/A converter circuit according to each of the embodiments described above is used as the D/A converter circuit 433. Among the reference voltage generating circuit, the selection signal generating circuit, and the selection circuit included in the reference-voltage-conversion-type D/A converter circuit according to each of the embodiments described above, the drive-circuit-integrated liquid crystal display unit shown in this example has the reference voltage generating circuit as an external circuit and has the selection signal generating circuit and the selection circuit formed on the LCD panel 44. The reference voltage lines, which transmit the externally supplied reference voltages to the selection circuit, are also wired on the LCD panel 44. However, the reference voltage generating circuit can be formed integrally with the pixel area 41 on the LCD panel 44.

The operation of the reference-voltage-selection-type D/A converter circuit according to the first embodiment shown in Fig. 1, that is, the reference-voltage-selection-type D/A converter circuit that converts the 4-bit digital data into the analog signals having the 16 voltage values will now be described as an example. In this circuit, 16-gradation display is realized by the 4-bit digital data (16 voltage values). The output line 15 in Fig. 1 corresponds to each of the data lines (signal lines) ..., 55n-1, 55n, 55n+1, ... in Fig. 8.

One reference voltage, for example, the smallest reference voltage Vref1, will now be described with reference to the timing chart in Fig. 2. When signals are sequentially written onto the pixel line by line every horizontal period, a gradation level (voltage value V1) of the lower two bits is written onto all of the data lines ..., 55n-1, 55n, 55n+1, .... After the time period for charging all the data lines, a gradation selection signal (the selection signal in Fig. 1) becomes at an "L" level at time t1. As a result, a signal line voltage corresponding to the gradation is determined. With respect to other gradations, the data lines ..., 55n-1, 55n, 55n+1, ... are charged in the same manner.

When the reference voltage Vref1 changes into the next gradation level (the voltage value V2) and the gradation selection signal becomes at an "L" level at time t2, the voltage value V2 is written onto all of the data lines corresponding to the levels other than the first written gradation level. Since the first gradation level (the voltage value V1) has been already written, this time period, that is, the time period from t1 to t2, may be short owing to only a short writing time being required. In other words, adoption of a circuit configuration in which time-shared writing is carried out allows the writing time of each gradation level to be changed. Subsequently, the voltage values V3 and V4 are sequentially written onto the data lines. The operations for the lower two bits (four gradations) are repeated in this manner.

As described above, when the reference-voltage-selection-type D/A converter circuit according to the first embodiment described above is used as a D/A converter circuit included in the drive circuits in the drive-circuit-integrated liquid crystal display unit, only four reference voltage lines are required in this D/A converter circuit and the selection circuit 13 can consist of a much smaller number of transistors. Therefore, significant reduction in circuit size, including wiring space for the reference voltage lines, can be achieved. This allows the frame, in which the drive circuit including this D/A converter circuit is arranged, and the LCD panel 44 to be reduced in size.

Additionally, since the number of the transistors is significantly decreased, individual transistor size can be increased in accordance with extra arrangement space caused by this decrease and large current flows through the transistors. Therefore, the writing property onto the data lines ..., 55n-1, 55n, 55n+1, ... can be improved. Furthermore, the decrease in the number of the reference voltage lines makes it possible to reduce power consumption by the amount for driving the capacity of the decreased reference voltage lines, thereby achieving low power consumption in the whole liquid crystal display unit.

Although the case where the reference-voltage-selection-type D/A converter circuit according to the first embodiment is used has been described here by way of example, the reference-voltage-selection-type D/A converter circuits according to the second and third embodiments described above can also be used. In such cases, the same operative effects can be gained.

Next, the reason why the digital data is divided into high-order bits and low-order bits will now be described. In order to provide gradation levels by time-sharing, a method in which one reference voltage has all the gradation levels (voltage values) in time series and these gradation levels are selected by time-sharing based on the digital data may be realized. However, with such a method, it takes a long time to sequentially write two voltage values whose gradation levels greatly differ from each other.

This method requires a large current to flow for writing the voltage values for a short time. However, in order to process the large current, the MOS transistors included in a gradation selection circuit must be large. As a result, the size of the reference-voltage-selection-type D/A converter circuit increases, so that it becomes difficult to include the drive circuit having the D/A converter circuit within the limited space of the frame in the drive-circuit-integrated liquid crystal display unit, or the frame size increases by the inclusion of the drive circuit having the D/A converter circuit.

In contrast, when the digital data is divided into the high-order bits and the low-order bits, it is possible to select one reference voltage divided into larger units with the high-order bits of the data and then to select by time-sharing, with respect to the selected reference voltage, the voltage values which are divided into smaller units and arranged in time series, with the low-order bits of the data. Thus, an electric potential can be set to a small value when sequentially writing the voltage values, thereby writing the voltage values for a short time. In such a case, since the voltage values can be written by supplying the transistors included in the gradation selection circuit with a small current, the size of the transistors can be reduced. As a result, the reference-voltage-selection-type D/A converter circuit and the frame thereof can be further reduced in size.

Although the present invention is described in the context that the D/A converter circuit is applied to the liquid crystal display unit, the application is not limited to this context. The D/A converter circuit can be applied to general drive-circuit-integrated display units such as EL display units. The reference-voltage-selection-type D/A converter circuit according to each of the above embodiments is not limitedly applied to a drive-circuit-integrated display unit. It can also be used as the D/A converter circuit in a display unit in which the drive circuit is provided in parts other than the LCD panel.

The drive-circuit-integrated liquid crystal display unit described in the above context is included in a mobile terminal such as a mobile telephone or a PDA as an output display. Fig. 9 is an external view schematically showing the structure of a mobile terminal according to the present invention, for example, a mobile telephone.

The mobile telephone in this example has the structure in which a speaker 62, a display 63, an operation panel 64, and a microphone 65 are arranged on the front side of a casing 61, these parts being arranged in this order from the upper side of the casing. In the mobile telephone having such a structure, for example, a liquid crystal display unit serves as the display 63. The drive-circuit-integrated liquid crystal display unit described in the above context is used as this liquid crystal display unit.

Since the LCD panel can be reduced in size in the drive-circuit-integrated liquid crystal display unit described in the above context, the use of such a drive-circuit-integrated liquid crystal display unit in the mobile telephone as the display 63 can greatly contribute to a more compact body of the mobile telephone and can reduce power consumption. Therefore, longer allowance time for the continuous service with battery power supply can be realized.

Although the case where the drive-circuit-integrated display unit is included in the mobile telephone is described here, the application thereof is not limited to this case. It can be included in general mobile terminals such as remote stations of extension telephones or PDAs.

As described above, according to the present invention, in the reference-voltage-selection-type D/A converter circuit, the display unit with a drive circuit that includes such a D/A converter circuit, or the mobile terminal having such a display unit as a display, the D/A converter circuit is configured so as to generate the reference voltages having voltage values corresponding to a plurality of signal levels (a plurality of gradation levels for the display unit) in time series and to select by time-sharing one of the voltage values corresponding to the signal levels in the reference voltages based on bit information concerning the digital data. Such a structure allows the number of the reference voltage lines for transmitting the reference voltages and that of the transistors included in the selection circuit to be reduced, thereby achieving reduction in circuit size and allowing adaptation to multi-gradation along with this reduction.

## Claims

1. A D/A converter circuit comprising:
reference voltage generating means for generating a reference voltage having voltage values corresponding to a plurality of signal levels in time series;
selection signal generating means for generating a selection signal for selecting one of the voltage values corresponding to the plurality of signal levels in the reference voltage based on bit information concerning digital data; and
selecting means for selecting by time-sharing one of the voltage values corresponding to the plurality of signal levels in the reference voltage based on the selection signal outputted from the selection signal generating means and for outputting an analog signal of the selected voltage value.

2. A D/A converter circuit according to Claim 1, wherein the reference voltage generating means generates as many reference voltages as the number of high-order bits of the digital data and sets as many voltage values as the number of low-order bits of the digital data with respect to each of these reference voltages, and
wherein the selection signal generating means generates the selection signal based on low-order bit information concerning the digital data.

3. A display unit comprising a pixel area, having many pixels arranged in a matrix, and a D/A converter circuit for converting digital data into an analog signal and for driving each of the pixels in the pixel area with the analog signal,
the D/A converter circuit including:
reference voltage generating means for generating a reference voltage having voltage values corresponding to a plurality of gradations in time series;
selection signal generating means for generating a gradation selection signal for selecting one of the voltage values corresponding to the plurality of gradations in the reference voltage based on bit information concerning the digital data; and
gradation selecting means for selecting by time-sharing one of the voltage values corresponding to the plurality of gradations in the reference voltage based on the gradation selection signal outputted from the selection signal generating means and for outputting an analog signal of the selected voltage value to each data line in the pixel area.

4. A display unit according to Claim 3, wherein the D/A converter circuit has at least a reference voltage line for transmitting the reference voltage from the selection signal generating means, the gradation selecting means, and the reference voltage generating means to the gradation selecting means, the reference voltage line being integrally formed with the pixel area on the same substrate.

5. A display unit according to Claim 4,
wherein the reference voltage generating means generates as many reference voltages as the number of high-order bits of the digital data and sets as many voltage values as the number of low-order bits of the digital data with respect to each of these reference voltages, and
wherein the selection signal generating means generates the gradation selection signal based on low-order bit information concerning the digital data.

6. A display unit according to Claim 3, wherein the D/A converter circuit sequentially writes signals onto the pixels in the pixel area line by line every horizontal period.

7. A display unit according to Claim 3, wherein an electro-optical device of the pixel is a liquid crystal cell.

8. A display unit according to Claim 3, wherein an electro-optical device of the pixel is an electroluminescense device.

9. A mobile terminal comprising a display unit as an output display, the display unit comprising a pixel area including many pixels arranged in a matrix; and a D/A converter circuit for converting digital data into an analog signal and for driving each of the pixels in the pixel area with the analog signal,
wherein the D/A converter circuit includes reference voltage generating means for generating a reference voltage having voltage values corresponding to a plurality of gradations in time series; selection signal generating means for generating a gradation selection signal for selecting one of the voltage values corresponding to the plurality of gradations in the reference voltage based on bit information concerning the digital data; and gradation selecting means for selecting by time-sharing and outputting one of the voltage values corresponding to the plurality of gradations in the reference voltage based on the gradation selection signal outputted from the selection signal generating means.

10. A mobile terminal according to Claim 9, wherein the display unit is a liquid crystal display unit.

11. A mobile terminal according to Claim 9, wherein the display unit is an electroluminescence display unit.
